(19) Europäisches Patentamt
European Patent Office
Office européen des brevets

(11) **EP 2 477 231 A2**

(12) **DEMANDE DE BREVET EUROPEEN**

(43) Date de publication:
**18.07.2012 Bulletin 2012/29**

(51) Int Cl.:
**H01L 31/0232** *(2006.01)*

(21) Numéro de dépôt: **11306668.2**

(22) Date de dépôt: **15.12.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **17.01.2011 FR 11503 N**

(71) Demandeur: **Commissariat à l'Énergie Atomique et aux Énergies Alternatives**
**75015 Paris (FR)**

(72) Inventeurs:
• **Espiau de Lamaestre, Roch**
**38000 GRENOBLE (FR)**

• **Boutami, Salim**
**38100 GRENOBLE (FR)**
• **Gravrand, Olivier**
**38120 FONTANIL-CORNILLON (FR)**
• **Le Perchec, Jérome**
**38000 GRENOBLE (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(54) **Photodétecteur optimisé par une texturation métallique agencée en face arrière**

(57) Détecteur à éclairage arrière pour la détection d'un rayonnement électromagnétique autour d'une longueur d'onde prédéterminée, comprenant :
- une couche semi-conductrice d'absorption (14), formée au dessus d'un milieu transparent, et apte à transmettre au moins une partie dudit rayonnement; et
- un miroir (22) au dessus de la couche semi-conductrice (14), et
- disposé entre le miroir (22) et la couche semi-conductrice (14), un réseau périodique (18) de motifs métalliques (20), le miroir (22) et le réseau (18) étant compris dans une couche de matériau (16) transparente audit rayonnement et formée sur la couche semi-conductrice (14).
Le miroir (22) et le réseau (18) vérifient :

$$d \leq \frac{\lambda}{\mathrm{Re}(n_1)}$$

$$\frac{\lambda}{16 \times \mathrm{Re}(n_2)} + m \times \frac{\lambda}{2 \times \mathrm{Re}(n_2)} \leq h \leq \frac{3 \times \lambda}{8 \times \mathrm{Re}(n_2)} + m \times \frac{\lambda}{2 \times \mathrm{Re}(n_2)}$$

$$\mathrm{Re}(n_2) \leq 1{,}3 \times \mathrm{Re}(n_1)$$

$$\mathrm{Re}(n_1) \geq \mathrm{Re}(n_{substrat})$$

EP 2 477 231 A2

où

■ *d* est la distance entre la couche semi-conductrice (14) et le réseau (18),

■ *h* est la distance entre le miroir (22) et le réseau (18),

■ *m* est un entier positif ou nul,

■ $\lambda$ est une longueur d'onde à laquelle la couche semi-conductrice (14) est absorbante,

■ $n_1$, $n_2$ et $n_{substrat}$ sont les indice de réfraction de la couche semi-conductrice (14), de la couche (16) et du milieu (12)

Rayonnement incident

# Fig. 1

**Description**

**DOMAINE DE L'INVENTION**

La présente invention a trait au domaine des détecteurs à forte efficacité quantique, et trouve particulièrement application dans le domaine des détecteurs à fine couche d'absorption.

**ETAT DE LA TECHNIQUE**

Comme cela est connu en soi, un photodétecteur comporte une couche semi-conductrice capable d'absorber des photons pour les convertir en des paires électrons-trous qui sont collectées pour générer un courant électrique.

L'efficacité quantique d'un photodétecteur, qui se définit comme le rapport entre le nombre de photons reçus par le photodétecteur et le nombre de photons absorbés par celui-ci, est donc la principale caractéristique qui détermine la qualité du photodétecteur. Cette efficacité étant liée à la capacité d'absorption de la couche semi-conductrice, on comprend aisément qu'un volume important de matériau semi-conducteur permet d'atteindre de hautes efficacités.

Toutefois, une couche semi-conductrice de volume réduit présente également un certain nombre d'avantages. Ainsi, les photodétecteurs à couche semi-conductrice à volume réduit présentent un coût de matériaux réduit, sont plus rapides, ou encore présentent un rapport signal sur bruit amélioré vis-à-vis du bruit de génération-recombinaison.

Cependant, la baisse de l'efficacité quantique en raison de la réduction du volume d'absorption s'accompagne également d'autres désavantages.

Notamment, à mesure que l'épaisseur de la couche semi-conductrice d'absorption diminue, cette dernière laisse passer de plus en plus de photons sans les absorber, et devient donc de plus en plus « transparente » au rayonnement à détecter.

Afin de renforcer l'absorption de la lumière dans des couches semi-conductrices minces déposées sur des substrats de croissance, il est ainsi usuellement envisagé des solutions placées en face arrière de la couche semi-conductrice, c'est-à-dire la face opposée à celle recevant le rayonnement incident, pour « récupérer » au moins une partie du rayonnement ayant traversé la couche semi-conductrice sans avoir été absorbé.

Une première solution consiste à placer un réflecteur plan, par exemple un miroir métallique ou un miroir de Bragg, en face arrière de la couche semi-conductrice de manière à renvoyer la lumière non-absorbée vers celle-ci. Cette solution permet un renforcement d'absorption par un double-passage de la lumière dans la couche semi-conductrice sans résonance particulière. Cette solution peut cependant s'avérer insuffisante dans le cas de couches très minces ou trop peu absorbantes, c'est-à-dire si la double-épaisseur parcourue ne permet pas encore une absorption totale.

Dans le cas où le miroir plan ne suffit pas, une autre solution consiste à utiliser un réflecteur arrière texturé, qui permet d'optimiser le renforcement de l'efficacité quantique en dirigeant le rayonnement davantage le long de la couche d'absorption. En effet, la texturation permet de réaliser un couplage du rayonnement à détecter avec un mode guidé de la couche semi-conductrice. Cette solution est nettement plus efficace que l'utilisation d'un simple miroir plan. Par ailleurs, elle utilise un phénomène de diffraction par un réseau qui rend sensible la détection à la longueur d'onde de la lumière incidente via la période du réseau. Ceci s'applique par exemple aux cellules solaires, comme illustré dans la référence « Optical Properties of Thin-film Silicon Solar Cells with Grating Couplers » de C. Haase and H. Stiebig, Progress in photovoltaics: research and applications, vol 14, p 629-641 (2006), avec un réseau de diffraction monodimensionnel de type à rainures en argent, d'une épaisseur typique de $\lambda/4n_{Si}$.

A ce titre, il est remarquable de noter que la texturation permet dans une certaine mesure de transformer un désavantage de la « transparence » de la couche semi-conductrice d'absorbation en un avantage. Ainsi, le gain d'efficacité quantique obtenu par le couplage au mode guidé de la couche semi-conductrice étant non négligeable, l'épaisseur de la couche semi-conductrice est choisie « mince » délibérément pour laisser passer une partie du rayonnement afin d'obtenir un couplage significatif par la texturation.

Par couche semi-conductrice « mince », on entend au sens de l'invention une couche semi-conductrice dont l'épaisseur est choisie de manière à ce qu'une partie du rayonnement d'intérêt traverse ladite couche sans être absorbée.

Par exemple, une couche semi-conductrice dont l'épaisseur $t$ vérifie $t \leq \dfrac{\lambda}{3 \times \mathrm{Im}(n_1)}$ , où $\lambda$ est la longueur d'onde à détecter, $n_1$ est l'indice de réfraction de la couche semi-conductrice et *Im* désigne la partie imaginaire, est considérée comme mince au sens de l'invention car elle laisse traverser la longueur d'onde à détecter. Cela correspond notamment à une épaisseur $t$ inférieure au micromètre dans le spectre infrarouge.

Par ailleurs, comme on peut le constater, l'épaisseur de la structuration dépend de la longueur d'onde objet de la détection. Ainsi lorsqu'on utilise ce type de structuration dans l'infrarouge, il est nécessaire de réaliser des structurations d'épaisseurs importantes. Or, il est difficile de structurer de telles épaisseurs d'un matériau métalliques en raison, par exemple, de problème de casquettes en lift off, de problèmes de remplissage de cavités profondes, des problèmes de contrôle de la profondeur d'une gravure profonde dans un diélectrique lorsqu'il s'agit de contrôler précisément l'épaisseur entre le fond de la cavité et la couche semi-conductrice absorbante, de problèmes de gravure de métaux nobles tels que l'or qui nécessitent des procédés à base de plasma à hautes températures, typiquement des températures supérieure à 200°C. Par exemple, le document WO2005/081782 divulgue un détecteur combinant un réflecteur arrière texturé avec une couche semi-conductrice d'absorption. Dans ce document, il est proposé d'utiliser un réseau de couplage de type « gaufre », placé en arrière d'une couche d'absorption formée d'un empilement de puits quantiques pour augmenter l'absorption dans une gamme de rayonnement infrarouge. Le réseau périodique de trous carrés a ici pour but de réfléchir le rayonnement traversant la couche d'absorption sans être absorbé tout en le dispersant dans celle-ci. Un renforcement de l'efficacité quantique est observé, mais ce renforcement est obtenu par la combinaison des puits quantiques et du réflecteur et nécessite en outre des structurations du réflecteur d'épaisseur de l'ordre d'un quart de la longueur d'onde, ce qui est très important lorsqu'on travaille dans l'infrarouge.

On observe par conséquent que pour les réflecteurs arrière texturés de l'état de la technique, l'épaisseur de la structuration est fortement couplée à la longueur d'onde à détecter, ce qui présente un certain nombre de désavantages, notamment dans le spectre infrarouge.

## EXPOSE DE L'INVENTION

Le but de l'invention est de résoudre le problème susmentionné de fort couplage entre l'épaisseur de la structuration d'un réflecteur et la longueur d'onde à détecter en proposant une architecture à base de texturation dont l'épaisseur n'est plus dépendante de cette longueur d'onde.

A cet effet, l'invention a pour objet un détecteur à éclairage arrière pour la détection d'un rayonnement électromagnétique autour d'une longueur d'onde prédéterminée, comprenant :

■ une couche semi-conductrice d'absorption pour l'absorption dudit rayonnement, formée au dessus d'un milieu au moins partiellement transparent audit rayonnement, et ayant une épaisseur apte à transmettre au moins une partie dudit rayonnement; et

■ un miroir disposé au dessus de la couche semi-conductrice pour réfléchir un rayonnement reçu au travers de celle-ci.

Selon l'invention, le détecteur comporte, disposé entre le miroir et la couche semi-conductrice, un réseau périodique de motifs métalliques, le miroir et le réseau périodique étant compris dans une couche de matériau au moins partiellement transparent audit rayonnement et formée sur la couche semi-conductrice.

Le miroir et le réseau périodique de motifs métalliques sont en outre conçus pour vérifier les relations suivantes :

$$d \leq \frac{\lambda}{\text{Re}(n_1)}$$

$$\frac{\lambda}{16 \times \text{Re}(n_2)} + m \times \frac{\lambda}{2 \times \text{Re}(n_2)} \leq h \leq \frac{3 \times \lambda}{8 \times \text{Re}(n_2)} + m \times \frac{\lambda}{2 \times \text{Re}(n_2)}$$

$$\text{Re}(n_2) \leq 1{,}3 \times \text{Re}(n_1)$$

$$\text{Re}(n_1) \geq \text{Re}(n_{substrat})$$

où :

- *Re* désigne la partie réelle ;

- $d$ est la distance entre la couche semi-conductrice (14) et le réseau périodique (18),
- $h$ est la distance entre le miroir et le réseau périodique,
- $m$ est un entier positif ou nul,
- $\lambda$ est une longueur d'onde à laquelle la couche semi-conductrice est absorbante,
- $n_1$ est l'indice de réfraction de la couche semi-conductrice,
- $n_2$ est l'indice de réfraction de la couche dans laquelle sont formés le réseau périodique et le miroir, et
- $n_{substrat}$ est l'indice de réfraction du milieu au dessus duquel est formée la couche semi-conductrice d'absorption.

En d'autres termes, l'invention consiste en une combinaison particulière d'un miroir et d'un réseau de diffraction qui produit une diffraction résonante du rayonnement dans la couche d'absorption. Notamment, des ordres diffractés évanescents emmagasinent de l'énergie au voisinage du réseau et peuvent être absorbés par la couche d'absorption voisine, sans que celle-ci soit en contact direct avec le réseau. Ces ordres peuvent redevenir propagatifs quand ils passent dans la couche d'absorption. Une partie de l'énergie est aussi absorbée par le métal, mais elle demeure faible, en particulier lorsque l'on choisit pour le réseau un métal noble tel que l'or, l'argent ou l'aluminium. Le miroir renvoie quant à lui la partie du flux diffractée dans le sens du rayonnement incident vers la couche d'absorption.

Notamment, il est possible grâce à l'invention d'obtenir une efficacité quantique de l'ordre de 80%, et ce même dans des détecteurs à couche mince avec un réseau de 50nm d'épaisseur pour une longueur d'onde de 4µm. Plus généralement, l'invention permet de réaliser un réseau périodique de motifs métalliques minces d'épaisseur typique inférieure à 100nm indépendamment de la longueur d'onde dans l'infrarouge. Comparativement à l'état de la technique qui nécessite, au mieux, une épaisseur de 500nm à cette même longueur d'onde, soit un gain d'un facteur de 5, voire même de 10, sur l'épaisseur à structurer.

Ainsi donc, hormis le fait d'obtenir spécifiquement une très haute efficacité quantique, l'invention permet d'une manière générale de bénéficier des avantages d'une structuration sans que l'épaisseur de celle-ci ne soit fortement couplée à la longueur d'onde du rayonnement à détecter.

Il est par ailleurs important de noter que l'invention ne reporte pas la difficulté de fabriquer des structurations métalliques d'épaisseur importante sur d'autres caractéristiques, comme par exemple la distance entre le réseau et la couche semi-conductrice.

En effet, l'invention permet l'emploi d'une technologique planaire, qui est aisée du fait de la faible épaisseur du réseau. La structure selon l'invention est donc facile à fabriquer, par exemple selon une technique de « *lift off* » sans emploi d'une épaisseur de résine trop importante, ou bien par gravure sans avoir à graver des épaisseur de l'ordre de grandeur de la longueur d'onde sur laquelle est réglée la couche d'absorption. En outre, la fabrication du miroir ne nécessite aucune étape de planarisation, car son design est tolérant à la structuration transférée lors du dépôt de la couche d'espace. Le miroir se comporte d'ailleurs de la même manière optiquement, qu'il soit parfaitement plan, ou bien nanostructuré.

Outre la possibilité offerte d'avoir une structuration dont l'épaisseur ne dépend plus de la longueur d'onde à détecter, l'invention présente d'autres avantages substantiels, au rang desquels on peut citer :

■ un renforcement de l'efficacité quantique à la fois pour la polarisation TM et la polarisation TE, et ce même avec un réseau monodimensionnel, lorsque $\frac{1}{5} \leq f \leq \frac{3}{4}$ où $f$ est le facteur de remplissage du réseau. L'invention ne nécessite pas de bi-périodisation du réseau pour fonctionner dans les deux polarisations ;

■ une robustesse aux variations géométriques, notamment en ce qui concerne le facteur de remplissage du réseau, de la distance séparant la couche d'absorption du réseau, ou de la distance séparant le réseau du miroir. Ceci permet d'envisager la fabrication simplifiée de matrices de pixels sensibles à des longueurs d'onde différentes (détection multispectrale) ;

■ il n'est pas nécessaire de structurer la couche semiconductrice ; et

■ l'utilisation de cette structure permet aussi d'ajuster la longueur d'onde de résonance (ie de renforcement d'absorption) via une dimension latérale du réseau (ici le pas du réseau principalement) et non par l'épaisseur des couches, ce qui permet d'envisager la formation facilitée de matrices de pixels sensibles à des longueurs d'onde différentes (détection multispectrale).

Ainsi donc, la structure selon l'invention permet de travailler, sans perte d'efficacité quantique, avec des volumes actifs plus petits que dans l'état de la technique, et donc d'obtenir de plus faibles bruits d'obscurité ou de travailler à moins basse température, ou encore d'opérer le détecteur à plus haute fréquence qu'usuellement. Elle permet aussi de réaliser une fonction de filtrage spectrale ou en polarisation par une structuration latérale de la couche métallique, dans le cas de détecteurs pixellisés.

Cette structure est également compatible avec le procédé de fabrication standard de la réalisation technologique

des détecteurs en $Hg_{1-x}Cd_xTe$ (Mercure Tellure Cadmium, abrégé en MCT) conçu pour la détection du rayonnement infrarouge proche à très lointain, suivant la fraction $\underline{x}$ en cadmium, et présente l'avantage de n'impliquer que des structurations métalliques de faibles épaisseurs, contrairement aux solutions de l'état de la technique qui reposent sur des structures métalliques d'épaisseurs importantes, difficiles à appliquer au rayonnement infrarouge , et d'autant plus qu'il est lointain. Dans une application privilégiée de l'invention, la couche semi-conductrice a une épaisseur inférieure à 500 nanomètres, et de préférence supérieure à 50 nanomètres. En d'autres termes, un renforcement de l'efficacité quantique sensible est même obtenu pour des couches d'absorptions minces à très minces.

Selon un mode de réalisation de l'invention, le réseau périodique de motifs métalliques est conçu pour vérifier la relation suivante :

$$\frac{\lambda}{\text{Re}(n_1)} \leq p \leq \frac{\lambda}{\max(\text{Re}(n_2), \text{Re}(n_{substrat}))}$$

où $p$ est le pas du réseau.

Comme expliqué ci-dessus, les relations précédentes portant sur la distance $d$, la hauteur $h$ et les indices $n_1$, $n_2$ et $n_{substrat}$ ont pour effet un renforcement de l'efficacité quantique par un phénomène de diffraction résonnante. Toutefois, en raison de la complexité des phénomènes électromagnétiques en cause, il n'est parfois pas garanti que le pic de résonnance se situe à la longueur $\lambda$. La relation portant sur la période $p$ a pour effet de régler le pic du phénomène de résonnance diffractant sensiblement sur la longueur d'onde $\lambda$. Il est remarquable de noter que la structure selon l'invention possède un réel degré de liberté pour fixer la position de la résonnance diffractant dans la gamme de longueurs d'onde absorbées par la couche semi-conductrice d'absorption.

Selon un mode de réalisation particulier, la couche semi-conductrice a une épaisseur inférieure à 500 nanomètres, et de préférence supérieure à 50 nanomètres.

Selon un mode de réalisation de l'invention, l'épaisseur $\underline{t}$ de la couche semi-conductrice vérifie la relation

$t \leq \dfrac{\lambda}{3 \times \text{Im}(n_1)}$ . Ceci garantit que le rayonnement n'est pas totalement absorbé par la couche semi-conductrice lors de son premier passage et qu'il voit donc l'influence du réseau.

Selon un mode de réalisation de l'invention, la distance entre le miroir et le réseau périodique est sensiblement égal à $\dfrac{\lambda}{4 \times \text{Re}(n_2)}$ ou un multiple impair de cette valeur. De cette manière, les interférences constructives du rayonnement dans la couche d'absorption sont favorisées, ce qui renforce davantage l'efficacité quantique.

Selon une variante de réalisation de l'invention, le réseau périodique est monodimensionnel, et est notamment constitué de barres métalliques. Avantageusement, le facteur de remplissage $f$ du réseau périodique vérifie la relation

$\dfrac{1}{5} \leq f \leq \dfrac{3}{4}$ .

Selon une autre variante de réalisation de l'invention, le réseau est bidimensionnel, et est notamment constitué de trous ou de plots. En d'autres termes, l'invention produit son effet de renforcement de l'efficacité quantique de manière identique en polarisation TM et en polarisation TE pour des géométries invariantes par rotation de 90° (exemple : réseaux de trou rond ou carré avec une maille carrée), ou de manière fortement différente dans les deux polarisations pour des géométries non invariantes par rotation de 90° (exemple : réseau de trous ronds ou carré avec une maille rectangulaire, ou réseau de trous rectangulaires avec une maille carrée, ...). Autrement dit, l'utilisation de réseau bi dimensionnel permet un contrôle accru de la réponse en polarisation.

Selon une variante de réalisation de l'invention, le miroir est métallique, et une face du miroir en regard du réseau périodique est texturée. Notamment, la texturation du miroir est réalisée sur une épaisseur $e$ vérifiant la relation

$e \leq \dfrac{\lambda}{10 \times \text{Re}(n_2)}$ .

Plus particulièrement, le réseau périodique et/ou le miroir sont réalisés en un métal à faibles pertes optiques, notamment en argent, en or, en cuivre ou en aluminium, ce qui permet de minimiser l'énergie absorbée par le métal constitutif du réseau et du miroir.

Selon une autre variante de l'invention, le miroir est un miroir de Bragg qui a l'avantage de ne pas absorber de rayonnement. Notamment, le miroir de Bragg comprend au moins un bicouche quart d'onde, constitué par exemple d'une couche en germanium d'une épaisseur de $\dfrac{\lambda}{4 \times \mathrm{Re}(n_{Ge})}$ et d'une couche en sulfure de zinc d'une épaisseur de $\dfrac{\lambda}{4 \times \mathrm{Re}(n_{ZnS})}$, où $n_{Ge}$ et $n_{znS}$ sont respectivement les indices de réfraction du germanium et du sulfure de zinc.

Selon un mode de réalisation de l'invention, le rayonnement à détecter est un rayonnement infrarouge, et en ce que l'épaisseur du réseau périodique est inférieure ou égale à 100 nm.

Selon un mode de réalisation de l'invention, la couche semi-conductrice d'absorption est constituée d'un matériau semi-conducteur choisi dans le groupe constitué du CdHgTe, du InGaAs et des semi-conducteurs ternaires de type III-V comprenant du Sb, InSb, SiGe ou du Ge.

Selon un mode de réalisation de l'invention, la distance *d* entre le réseau périodique et la couche semi-conductrice absorbante est nulle, le réseau reposant donc sur la couche semi-conductrice. Ceci permet la collecte électrique des photoporteurs générés au moyen du réseau lui-même qui sert alors d'électrode de collecte. L'avantage apporté par cette configuration est la vitesse accrue du photodétecteur puisque les photoporteurs n'ont pas à diffuser sur une longue distance avant d'être collectés.

Selon un autre mode de réalisation de l'invention, le détecteur comporte une diode de collecte comprenant :

- ■ une zone semi-conductrice formée dans la couche semi-conductrice d'absorption et de conductivité électrique opposée à celle de la couche semi-conductrice d'absorption ; et
- ■ une métallisation agencée au contact de la zone semi-conductrice pour la collecte de photoporteurs générés dans la couche semi-conductrice d'absorption.

Selon une variante, le réseau périodique, le miroir et la métallisation sont court-circuités.

Selon une autre variante, le réseau périodique et le miroir sont court-circuités et sont isolés électriquement de la métallisation.

Selon une autre variante, le réseau périodique, le miroir et la couche semi-conductrice d'absorption sont court-circuités, et ce que le réseau périodique et le miroir sont isolés électriquement de la métallisation.

Selon une autre variante, le miroir et la métallisation sont court-circuités et isolés électriquement du réseau périodique. Notamment, le réseau périodique et la couche semi-conductrice d'absorption sont court-circuités et isolés électriquement de la métallisation.

Selon une variante, la métallisation traverse sans contact le miroir et le réseau périodique.

## BREVE DESCRIPTION DES FIGURES

L'invention sera mieux comprise à la lecture de la description qui va suivre, donnée uniquement à titre d'exemple, et faite en relation avec les dessins annexés, dans lesquels des références identiques désignent des éléments identiques, et dans lesquels :

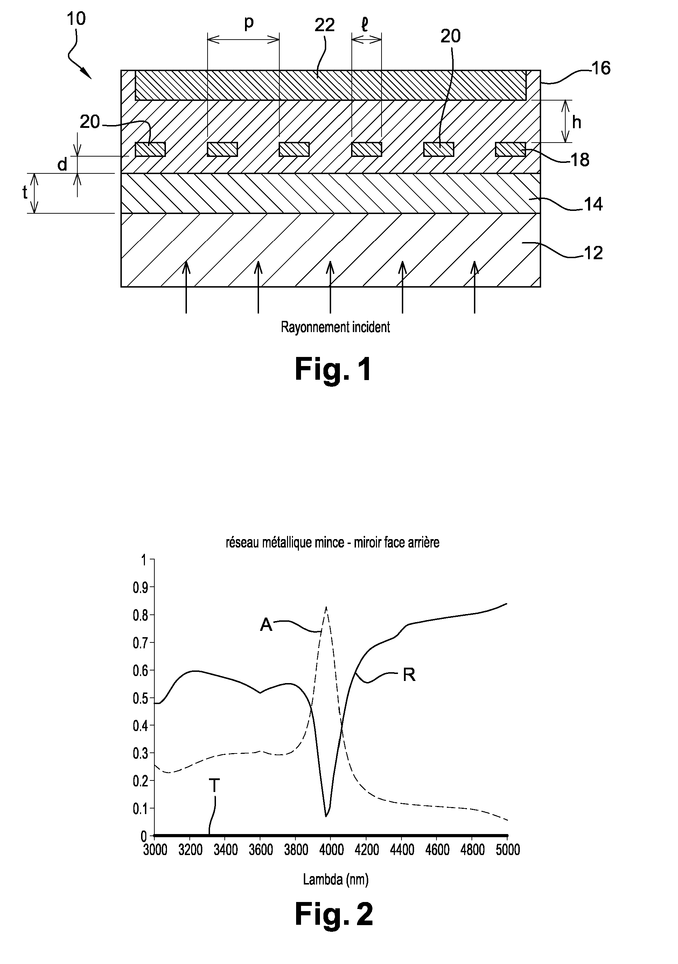

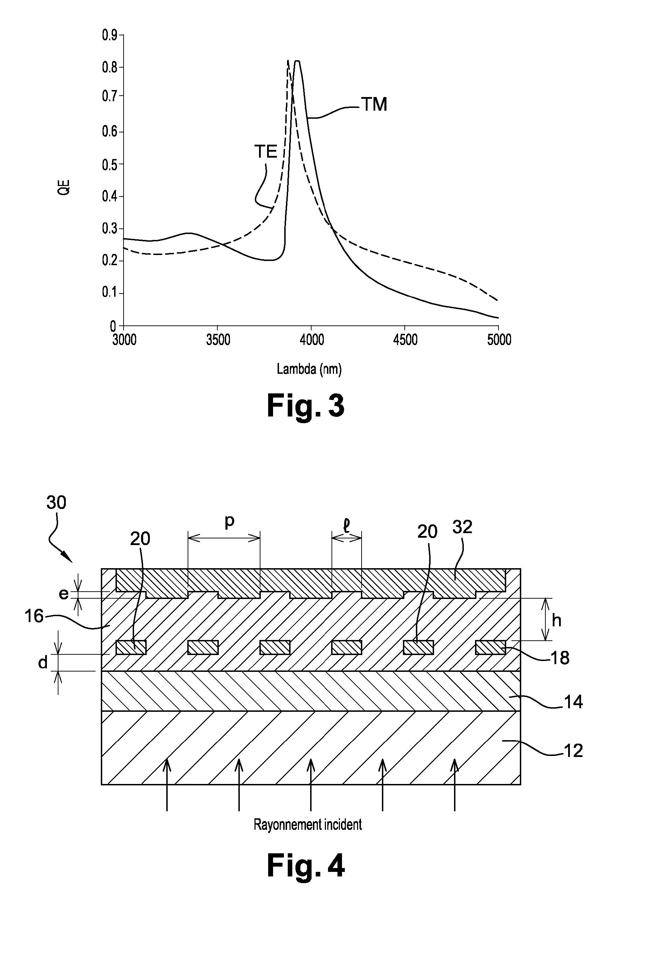

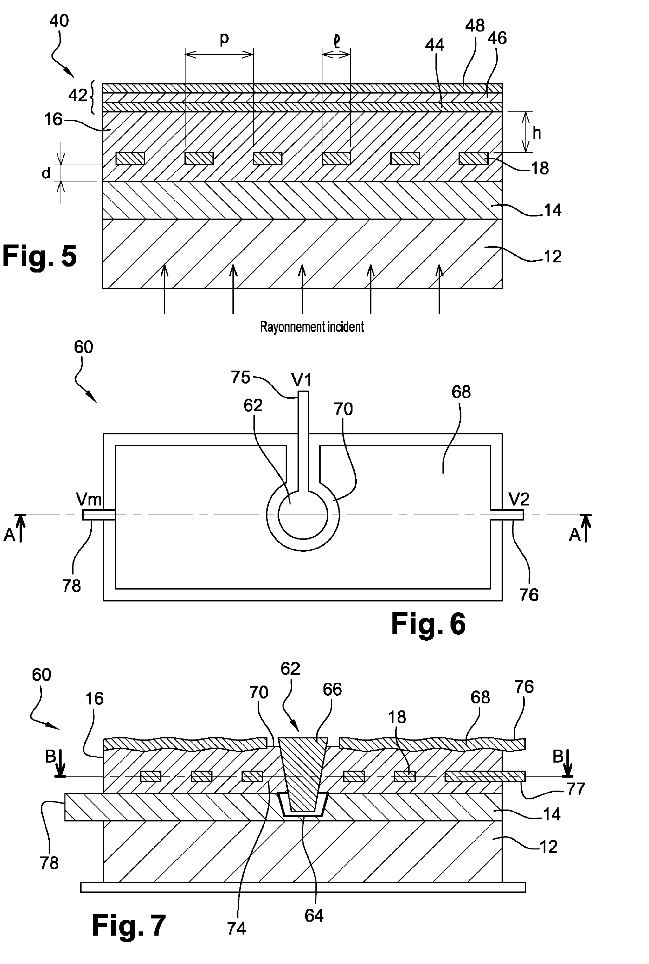

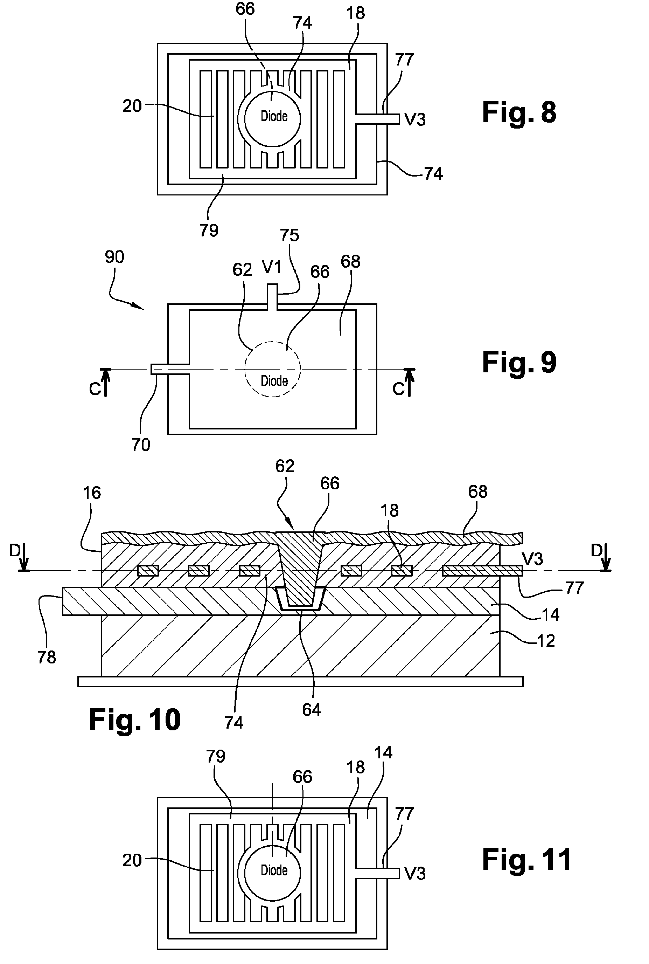

- ■ la figure 1 est une vue schématique en coupe d'un détecteur selon l'invention comprenant un miroir en arrière plan ;
- ■ la figure 2 est un tracé des courbes d'absorption, de transmission et de réflexion d'un exemple de réalisation du détecteur de la figure 1 ;
- ■ la figure 3 est un tracé de l'efficacité quantique de l'exemple de réalisation du détecteur pour la polarisation TM et la polarisation TE ;
- ■ la figure 4 est une vue schématique en coupe d'une variante de réalisation du détecteur de la figure 1 avec un miroir arrière texturé ;
- ■ la figure 5 est vue schématique en coupe d'une variante de réalisation du détecteur de la figure 1 avec un miroir arrière du type miroir de Bragg ;
- ■ la figure 6 est une vue schématique de dessus d'un détecteur selon l'invention comprenant une diode de collecte ;
- ■ la figure 7 est une vue schématique en coupe selon l'axe A-A du détecteur de la figure 6 ;
- ■ la figure 8 est une vue schématique en coupe selon l'axe B-B du détecteur de la figure 7 ;
- ■ la figure 9 est une vue schématique de dessus d'un détecteur selon une variante de l'invention ;
- ■ la figure 10 est une vue schématique en coupe selon l'axe C-C du détecteur de la figure 9 ;

7

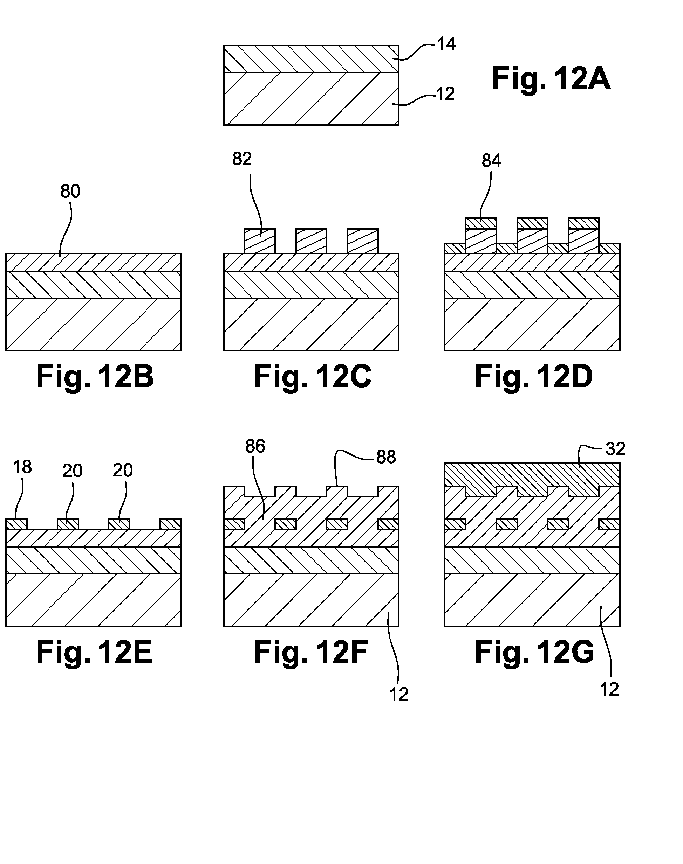

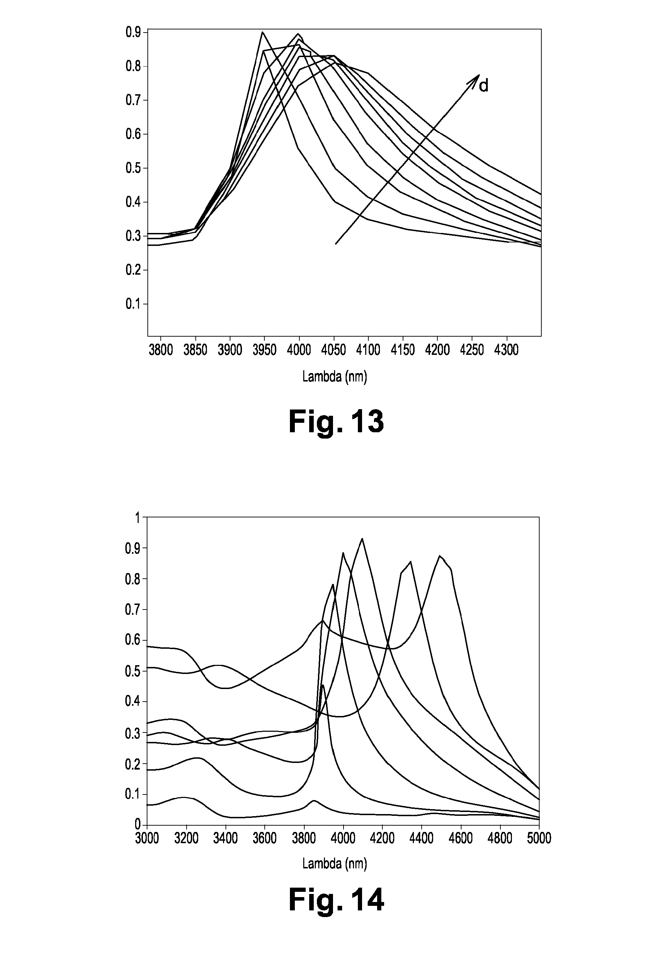

■ la figure 11 est une vue schématique en coupe selon l'axe D-D du détecteur de la figure 9 ;
■ les figures 12A à 12G sont des vues schématiques en coupe illustrant un procédé de réalisation d'un détecteur selon l'invention ;
■ la figure 13 est un tracé illustrant la réponse en absorption d'un détecteur selon l'invention en fonction de différentes valeurs de distance entre le réseau périodique de motifs périodiques et la couche semi-conductrice d'absorption ; et
■ la figure 14 est un tracé illustrant la réponse en absorption d'un détecteur selon l'invention en fonction de différentes valeurs d'épaisseur de la couche semi-conductrice d'absorption.

**DESCRIPTION DETAILLEE DE L'INVENTION**

En se référant à la figure 1, un détecteur **10** à éclairage arrière selon l'invention comprend :

■ un milieu **12** transparent, ou partiellement transparent, à un rayonnement incident dans une gamme de longueurs d'onde à détecter et d'indice de réfraction $n_{substrat}$. Le milieu **12** est dans cet exemple un substrat, par exemple en CdZnTe. En variante, le milieu est une couche d'air, la couche **14** étant par exemple suspendue au dessus d'un substrat;
■ une couche semi-conductrice d'absorption **14** formée sur le substrat **12** pour absorber le rayonnement et créer des paires électrons-trous. Cette couche **14** est choisie de manière à absorber une longueur d'onde particulière $\lambda$ de la gamme de longueurs d'onde considérée, l'absorption étant maximale pour cette longueur d'onde $\lambda$, et présente un indice de réfraction $n_1$. Par exemple, la couche **14** est constituée d'un matériau semi-conducteur choisi dans le groupe constitué du CdHgTe, du InGaAs et des semiconducteurs ternaires de type III-V comprenant du Sb, InSb, SiGe ou du Ge.. Par exemple, la couche **14** est constituée de HgCdTe dont l'indice de composition en Cd permet l'absorption à la longueur d'onde $\lambda$. L'épaisseur $t$ de la couche **14** est par ailleurs choisie pour que celle-ci laisse passer une partie du rayonnement à détecter; et
■ une couche **16** transparente, ou partiellement transparente, au rayonnement d'intérêt, électriquement isolante, et formée sur la couche d'absorption **14** et d'indice de réfraction $n_2$.

La couche **16** comporte :

■ un réseau périodique de motifs monodimensionnels **18** disposé à une distance $d$ de la couche d'absorption **14**. Le réseau périodique **18**, de pas $p$ et de facteur de remplissage $f$, est par exemple constitué de barres métalliques **20** parallèles de section rectangulaire et de largeur $l$. Le facteur de remplissage $f$ du réseau **18** est dans cet exemple égal à $f = \dfrac{l}{p}$. L'épaisseur du réseau étant indépendante des phénomènes de résonnance et de la longueur d'onde absorbée, elle est choisie fine, typiquement inférieure à 100 nanomètres. La géométrie du réseau **18**, notamment son pas $p$, permet de régler la longueur d'onde de résonnance ; et
■ un miroir métallique plan **22**, disposé au dessus du réseau périodique **18** à une distance $h$ de celui-ci.

Par ailleurs, le réseau périodique 18 et le miroir 22 satisfont les relations suivantes :

$$d \leq \frac{\lambda}{\mathrm{Re}(n_1)} \tag{1}$$

$$\frac{\lambda}{16 \times \mathrm{Re}(n_2)} + m \times \frac{\lambda}{2 \times \mathrm{Re}(n_2)} \leq h \leq \frac{3 \times \lambda}{8 \times \mathrm{Re}(n_2)} + m \times \frac{\lambda}{2 \times \mathrm{Re}(n_2)} \tag{2}$$

$$\frac{\lambda}{\mathrm{Re}(n_1)} \le p \le \frac{\lambda}{\max\left(\mathrm{Re}(n_2), \mathrm{Re}(n_{substrat})\right)} \qquad (3)$$

$$\mathrm{Re}(n_2) \le 1,3 \times \mathrm{Re}(n_1) \qquad (4)$$

$$\mathrm{Re}(n_1) \ge \mathrm{Re}(n_{substrat}) \qquad (5)$$

où *m* est un entier positif ou nul,

Comme dit précédemment, un tel agencement permet de réaliser une diffraction résonnante dans la couche semi-conductrice d'absorption **14**, ce qui a pour effet, notamment, de renforcer sensiblement l'efficacité quantique du détecteur **10**.

De préférence, la distance *d* entre le réseau périodique et le couche semi-conductrice **14** vérifie la relation $d < \frac{\lambda}{4 \times \mathrm{Re}(n_1)}$. De cette manière, le champ électrique localisé proche du réseau périodique **18** pénètre plus fortement dans la couche semi-conductrice **14**, ce qui renforce davantage l'efficacité quantique.

De préférence, l'épaisseur de la couche semi-conductrice **14** vérifie la relation $t \le \frac{\lambda}{3 \times \mathrm{Im}(n_1)}$, où Im désigne la partie imaginaire. Ceci garantit que le rayonnement n'est pas totalement absorbé par la couche semi-conductrice **14** lors de son premier passage et qu'il voit donc l'influence du réseau périodique **18**.

De préférence, la distance *h* entre le miroir **22** et le réseau périodique **18** est sensiblement égale à $\frac{\lambda}{4 \times \mathrm{Re}(n_2)}$ ou un multiple impair de cette valeur. De cette manière, les interférences constructives du rayonnement dans la couche semi-conductrice d'absorption **14** sont favorisées, ce qui renforce davantage l'efficacité quantique.

De préférence, le facteur de remplissage *f* du réseau périodique **18** est proche de 50% pour favoriser une forte diffraction.

De préférence, le facteur de remplissage *f* vérifie la relation $\frac{1}{5} \le f \le \frac{3}{4}$, ce qui permet un renforcement de l'efficacité quantique à la fois pour la polarisation TM et la polarisation TE, et ce même dans le cas où le réseau périodique **18** est monodimensionnel.

De préférence, le réseau périodique **18** et le miroir métallique **22** sont réalisés en un métal à faibles pertes optiques, par exemple en argent, en or, en cuivre, en aluminium, ou en un alliage de ceux-ci, ce qui permet de minimiser l'énergie absorbée par le métal constitutif du réseau **18** et du miroir **22**. De manière avantageuse, le réseau **18** et le miroir **22** comprennent également une fine couche d'accroche, tel que par exemple du Ti, qui favorise le dépôt ultérieur du métal du réseau périodique **18** et du miroir **22**.

Il va à présent être décrit en relation avec les figures 2 et 3, les performances d'un détecteur selon le premier mode de réalisation pour une absorption d'un rayonnement dans la gamme des infrarouges moyens (3-5 µm).

Dans cet exemple de réalisation, le substrat **12** est en CdZnTe et la couche semi-conductrice d'absorption **14** est réalisée en CdHgTe pour une absorption dans l'infrarouge moyen. L'indice de composition en Cd du MCT de la couche **14** est égal à 0,3, de sorte que la longueur d'onde λ est comprise entre 3 et 5µm et vaut 4 µm.

L'épaisseur de la couche semi-conductrice **14** est inférieure à $\frac{\lambda}{3 \times \mathrm{Im}(n_1)}$, dans cet exemple une épaisseur de 300 nanomètres.

La couche **16**, dans laquelle sont réalisés le réseau périodique **18** et le miroir **22**, est constituée de ZnS et le réseau périodique **18**, réalisé en Au, est disposé à une distance $\underline{d}$ de 50 nanomètres de la couche de MCT **14**, soit une distance $\underline{d}$ d'environ $\dfrac{\lambda}{40 \times \mathrm{Re}(n_1)}$. Le miroir **22**, également réalisé en Au, est quant à lui disposé à une distance $\underline{h}$ de 500 nanomètres du réseau périodique **18**, soit une distance $\underline{h}$ d'environ $\dfrac{\lambda}{4 \times \mathrm{Re}(n_2)}$.

Par ailleurs, le pas $\underline{p}$ du réseau périodique **18** est de 1,45 $\mu$m, c'est-à-dire une valeur d'environ $1{,}25 \times \lambda/n_1$, et la largeur $\underline{l}$ des barres métalliques **20** est égale à 500 nanomètres, de sorte que le facteur de remplissage $\underline{f}$ du réseau **18** est égal à 34%.

Enfin, en fonctionnement, le détecteur est refroidi à une température de 77K.

La figure 2 illustre la réponse de ce détecteur en absorption (courbe « A »), en réflexion (courbe « R »), et en transmission (courbe « T ») dans la gamme de longueurs d'onde 3-5 $\mu$m, en supposant que tout porteur photogénéré est collecté. La figure 3 illustre l'efficacité quantique dans cette même gamme pour les polarisations TM et TE.

Comme il est possible de le constater, le détecteur selon l'invention présente une efficacité quantique maximale supérieure à 80%, et ce quelle que soit la polarisation du rayonnement incident. 10% restant sont absorbés par les éléments métalliques de la structure, et les derniers 10% sont réfléchis.

On notera qu'en remplaçant le réseau et le miroir par un simple miroir métallique plan, comme cela est le cas de l'état de la technique, on aboutirait à seulement 30% d'efficacité quantique, et ce quelle que soit la distance de ce miroir à la couche active **14**.

Il a été décrit un détecteur muni d'un miroir métallique plan **22**. En variante, comme cela est illustré à la figure 4, le miroir métallique plan **22** est remplacé par un miroir métallique texturé **32** présentant par exemple un motif complémentaire à celui du réseau périodique **18**. Par exemple, une barre métallique **20** fait face à un renfoncement de même surface réalisée dans le miroir **32**.

En variante, comme cela est illustré à la figure 5, le miroir métallique plan **22** est remplacé par un miroir de Bragg **42**, par exemple formé de trois bicouches **44**, **46**, **48** constituées chacune d'une couche en germanium d'une épaisseur de $\dfrac{\lambda}{4 \times \mathrm{Re}(n_{Ge})}$ et d'une couche en ZnS d'une épaisseur de $\dfrac{\lambda}{4 \times \mathrm{Re}(n_{ZnS})}$, où $n_{Ge}$ et $n_{ZnS}$ sont respectivement les indices de réfraction du germanium et du sulfure de zinc.

La figure 6 est une vue schématique de dessus d'un détecteur **60** selon l'invention. Les figures 7 et 8 sont des vues schématiques respectivement en coupe de ce même détecteur selon les axes A-A et B-B respectivement. Le détecteur **60** comporte une diode de collecte **62**. La diode de collecte **62** comporte une zone semi-conductrice **64**, par exemple dopée n, de conductivité électrique opposée à celle de la couche d'absorption **14**, par exemple dopée p, de manière à former une jonction PN, et une métallisation **66**, par exemple tronconique, formant électrode de collecte, traversant la couche **16** et étant en contact avec la zone semi-conductrice **64** pour la collecte des photoporteurs.

Le miroir arrière **68** est de préférence texturé pour les raisons évoquées ci-dessus, et se présente par exemple sous la forme d'ondulations, et comporte une ouverture **70** pour la métallisation **66**, de manière à éviter tout court-circuit entre le miroir **68** et la métallisation **66**. De même, le réseau périodique **18** comporte une ouverture **74** pour la métallisation 66 afin d'éviter tout court-circuit entre ceux-ci

De manière avantageuse, la métallisation **66** est réalisée dans le même métal que le miroir **68**, ce qui permet la fabrication simultanée de ces deux éléments.

Par ailleurs, la métallisation **66**, le miroir **68**, le réseau périodique **18** et la couche semi-conductrice **14** comprennent respectivement des contacts **75**, **76**, **77**, **78** pour pouvoir être portés à des potentiels différents, notamment un premier potentiel $\underline{V_1}$ pour la métallisation **66**, un second potentiel $\underline{V_2}$ pour le miroir **68**, un troisième potentiel $\underline{V_3}$ pour le réseau **18** et un quatrième potentiel $\underline{V_m}$, égal au potentiel de la masse, pour la couche semi-conductrice **14**. Comme illustré à la figure 8, les motifs du réseau périodique **18** sont électriquement connectés entre eux pour pouvoir être portés au même potentiel **$V_3$**. Par exemple, si les motifs sont des barres métalliques parallèles **20** telles que précédemment décrites, celles-ci sont comprises dans un cadre métallique **79** comportant le contact **77**.

La collecte des photoporteurs via la diode de collecte **62** s'effectue de la manière suivante.

La différence de potentiel appliquée entre les contacts **75** et **78** induit une chute de potentiel au niveau de la zone de charge d'espace formée par le contact entre la couche semi-conductrice **14** et la zone semi-conductrice **64**. La diode de collecte **62** est donc polarisée en légère tension inverse. Les photoporteurs générés majoritairement sous le réseau périodique **18** qui diffusent jusqu'à cette zone de charge d'espace sont donc collectés au moyen de la métallisation **66**.

En outre, deux capacités du type métal/isolant/semiconducteur sont formées par la combinaison du miroir métallique **68**, de la couche isolante **16**, et de la couche semi-conductrice **14**, et par la combinaison du réseau métallique **18**, de la couche isolante **16**, et de la couche semi-conductrice **14**. Ainsi, la différence de potentiels appliquée entre les contacts **76** et **78** et la différence de potentiels appliqués entre les contacts **77** et **78**, permettent chacune, ou en combinaison, de moduler par effet de champ la distribution de photoporteurs générés dans la couche semi-conductrice **14**, de manière à diminuer le bruit et à augmenter l'efficacité de la collecte de charge.

Si par exemple on considère une couche semi-conductrice **14** dopé de type p, l'application d'une différence de potentiel différente de la tension de bande plate de l'empilement métal/isolant/semiconducteur décrit ci-dessus entre les contacts **76** et **78** et/ou les contacts **77** et **78** permet de former une couche de déplétion localisée dans la couche semi-conductrice **14** et directement sous l'interface entre celle-ci et la couche **16**. Cette zone de déplétion masque donc cette interface aux photoporteurs, ce qui diminue la probabilité de recombinaison électron-trou localement sous cette interface, sur des défauts électriques plus nombreux à cet endroit qu'au centre de la couche semi-conductrice **14**.

Il y a ainsi plusieurs configurations privilégiées de polarisation électrique du détecteur **60** :

1) Configuration dans laquelle le miroir **68**, le réseau **18** et la métallisation **66** sont court-circuités, c'est-à-dire électriquement connectés : le potentiel de ces trois éléments $V_1=V_2=V_3$ sert à définir la tension de polarisation $V_1-V_m$ de la diode de collecte **62** conformément au fonctionnement de l'état de l'état de la technique des détecteurs CdHgTe pour ce qui concerne la collecte des photoporteurs ;

2) Configuration dans laquelle le miroir **68** et le réseau **18** sont court-circuités et isolés électriquement de la métallisation **66**: le potentiel du miroir **68** et du réseau **18** $V_2=V_3$ sert de garde électrostatique, avec l'avantage décrit ci-dessus de l'effet de masquage électrique de l'interface supérieure de la couche semi-conductrice **14**, la polarisation de la diode de collecte **62** étant $V_1-V_m$;

3) Configuration dans laquelle le miroir **68**, le réseau **18** et la couche semi-conductrice **14** sont court-circuités par exemple à la masse et dans laquelle le miroir **68** et le réseau **18** sont isolés électriquement de la métallisation **66** : ces trois éléments sont portés au même potentiel $V_2=V_3=V_m$ et la diode de collecte 62 est polarisée par la tension $V_1-V_m$, conformément au fonctionnement de l'état de la technique des détecteurs CdHgTe pour ce qui concerne la collecte électrique. L'avantage d'une telle configuration est la limitation de la capacité parasite générée par la grande proximité entre la couche semiconductrice et les parties métalliques **18**, **68.**

La figure 9 est une vue schématique de dessus d'un détecteur **90** selon une variante de l'invention. Les figures 10 et 11 sont des vues schématiques respectivement en coupe de ce même détecteur selon les axes C-C et D-D respectivement.

Le détecteur **90** diffère du détecteur **60** précédemment décrit en ce que la métallisation **66** et le miroir **68** ne forment qu'une seule pièce, l'ouverture **70** étant absente. La métallisation **66** et le miroir **68** sont ainsi portés au même potentiel $V_1$ moyen du contact **75**, le contact **76** étant omis.

On évite ainsi la fuite de photons non absorbés par la couche de semiconducteur **14**, ce qui permet de renforcer l'efficacité quantique d'absorption. En effet, dans le détecteur **60** précédemment décrit, l'écart entre la métallisation **66** et le miroir **68** doit être supérieur ou égal à la résolution latérale du processus technologique utilisé pour réaliser le détecteur, par exemple la méthode de lithographie. Cet écart peut être non négligeable, par exemple 1 micron, pour des technologies de lithographie UV faible coût. Cette configuration du détecteur **90** présente l'avantage supplémentaire d'être plus simple à réaliser du fait de l'absence de l'ouverture **70**. L'avantage de la configuration du détecteur **60** permettant l'application d'un potentiel différent au contact **76** par rapport au contact **75**, rendue possible par l'ouverture **70**, est que le potentiel appliqué par le contact **76** est plus homogène spatialement que le potentiel appliqué par le réseau via le contact **77**, à la différence de la configuration du détecteur **90**.

La collecte des photoporteurs via la diode de collecte **62** dans le détecteur **90** s'effectue de manière analogue à celle décrite en relation avec le détecteur **60** à la seule différence qu'il n'est pas possible d'appliquer une tension de grille indépendante via le miroir **68**, la répartition des charges photogénérées n'étant déterminée que par le potentiel appliqué au réseau **18**. De manière analogue au détecteur **60**, les configurations suivantes sont applicables au détecteur **90** :

1) Configuration dans laquelle le réseau **18** et la métallisation **66** (et donc le miroir **68**) sont court-circuités : le potentiel de ces trois éléments $V_1=V_2=V_3$ sert à définir la tension de polarisation $V_1-V_m$ de la diode de collecte **62** conformément au fonctionnement de l'état de l'état de la technique des détecteurs CdHgTe pour ce qui concerne la collecte des photoporteurs ;

2) Configuration dans laquelle réseau **18** et la métallisation **66** sont isolés : le potentiel $V_3$ du réseau **18** sert de garde électrostatique, avec l'avantage décrit ci-dessus de l'effet de masquage électrique de l'interface supérieure de la couche semi-conductrice **14**, la polarisation de la diode de collecte **62** étant $V_1$-$V_m$;

3) Configuration dans laquelle le réseau **18** et la couche semi-conductrice **14** sont court-circuités par exemple à la masse et dans laquelle le réseau **18** est isolé électriquement de la métallisation **66** : ces deux éléments sont portés au même potentiel $V_3$=$V_m$, la diode de collecte **62** est polarisée par la $V_1$-$V_m$, conformement au fonctionnement de l'état de la technique des détecteurs CdHgTe pour ce qui concerne la collecte électrique. L'avantage d'une telle configuration est la limitation de la capacité parasite générée par la grande proximité entre la couche semi-conductrice **14** et les parties métalliques **18**, **68**. Cette limitation de la capacité sera moindre que pour la même configuration du détecteur **60**, car il subsistera une capacité parasite entre le réseau **18** et le miroir **68**. Cependant, étant donné le dimensionnement de la structure, l'épaisseur entre le réseau **18** et le miroir **68** étant environ dix fois supérieure à l'épaisseur entre le réseau **18** et la couche semi-conductrice **14**, cette capacité sera moindre de celle la configuration 1) ci-dessus.

Il a été décrit un mode de réalisation dans lequel une diode de collecte est prévue pour collecter les photoporteurs générés dans la couche semi-conductrice **14**.

Dans une variante dans laquelle la diode de collecte **62** n'est pas prévue, ou de manière complémentaire à la diode de collecte **62**, le réseau périodique **18** est utilisé en tant qu'électrode de collecte en formant celui-ci au contact de la couche semi-conductrice d'absorption **14** ($d$ = 0). L'avantage de cette configuration est la vitesse accrue du détecteur puisque les photoporteurs n'ont pas à diffuser sur une longue distance avant d'être collectés. En effet, tout point de la couche semi-conductrice d'absorption **14** est proche d'un des motifs métalliques du réseau **18**, minimisant ainsi la distance entre le lieu d'une génération de photoporteurs et le lieu de leur collecte.

Il a été décrit des détecteurs dans lesquels le réseau périodique est monodimensionnel. Un tel réseau permet le renforcement de l'efficacité quantique quelle que soit la polarisation du rayonnement incident. Toutefois, comme le montre la figure 3, la réponse spectrale n'est pas rigoureusement identique pour chacune des polarisations. Afin de faciliter la réalisation du détecteur insensible à la polarisation, ou bien d'obtenir un contrôle indépendant sur la réponse de chacune des polarisations, le réseau périodique est avantageusement bidimensionnel, et présente donc une périodicité selon deux directions orthogonales. Par exemple, le réseau périodique **18** est remplacé par un réseau de maille carrés sous la forme de plots métalliques carrés ou circulaires formés dans la couche **16** ou d'une membrane métallique mince agencée dans la couche **16** et percées d'ouvertures carrées ou circulaires selon une maille carrée.

Dans ce cas de réseau bi périodique de plots métalliques, le potentiel des plots est flottant. Grâce à la configuration de potentiel décrite aux figures 6, 7 et 8, il est possible de contrôler indépendamment la différence de potentiel servant à la collecte à travers la diode de collecte **62** et la différence de potentiel servant à modifier la distribution de charges photogénérées dans la couche semi-conductrice **14**.

Dans le cas contraire de réseau bi périodique d'ouvertures métalliques, il y a continuité électrique du réseau métallique **18** et les procédures décrites en figures 6 à 11 sont applicables

Les dimensions et distances associées à ces réseaux périodiques bidimensionnels sont les mêmes que celles du réseau **18** d'un réseau de lignes sauf pour la largeur de la structuration. Pour cette dernière, on a alors $\dfrac{p}{4} \leq l \leq p$ ,

la largeur $l$ étant ici la largeur des plots dans le cas d'un réseau de plots minces carrés, ou la largeur de l'espace métallique entre deux trous dans le cas d'un réseau de trous dans une membrane mince métallique.

Un procédé de fabrication d'un détecteur selon l'invention, par exemple celui de la figure 4, est à présent décrit en relation avec les figures 12A à 12G.

Le procédé de fabrication commence par la croissance sur un substrat **12**, par exemple en CdZnTe d'une couche semi-conductrice **14** absorbant le rayonnement incident d'intérêt, comme par exemple une couche en MCT de 300 nanomètres d'épaisseur (figure 12A).

Le procédé se poursuit alors par le dépôt d'une couche de protection **80**, par exemple en ZnS de 50 nanomètres d'épaisseur (figure 12B). Une couche de résine électronique ou optique est ensuite déposée sur la couche de protection **80**, puis une lithographie électronique ou UV est réalisée pour insoler des motifs **82** d'une épaisseur de quelques centaines de nanomètres, par exemple 500 nanomètres (figure 12C).

Après développement de la résine, une étape de « *lift off* » de métal **84**, par exemple de l'Au, est mise en oeuvre pour former le réseau périodique (figure 12D). En outre, l'épaisseur du métal **84** est choisie fine, par exemple 50 nanomètres, ce qui est très favorable au succès de cette étape de « *lift off* ». Cela permet notamment d'éviter la formation de défauts du type « casquettes ».

Le métal **84** recouvrant les motifs **82** est alors ôté en même temps que la résine restante **82**, par exemple par un solvant de type acétone, de manière à ne laisser que le réseau périodique **18** (figure 12E).

Le procédé se poursuit alors par l'encapsulation du réseau périodique **18** par un matériau **86** d'indice de réfraction inférieur à celui de la couche semi-conductrice d'absorption **14**, sur l'épaisseur _h_ de manière à respecter l'espacement approprié entre le réseau et le miroir.

Ce matériau pourra par exemple être du ZnS présentant une épaisseur de 500 nanomètres. Cependant, d'autres matériaux peuvent être utilisés. Des motifs **88** sont ainsi formés au dessus des motifs **20** du réseau périodique **18** (figure 12F) par exemple au moyen d'une pulvérisation cathodique.

Le dépôt du miroir **32**, par exemple par dépôt d'une couche d'accroche en Ti de 10 nm d'épaisseur suivi du dépôt d'une couche d'Au d'une épaisseur de 150 nm, l'or étant alors suffisamment épais pour éviter toute transmission de lumière à travers cette dernière couche (figure 12G).

Ce miroir **32** se retrouve ainsi structuré avec la même période que le réseau périodique **18**, la forme du motif répété dépendant de la nature des couches et des méthodes de dépôt de celles-ci par-dessus le réseau périodique **18**. Notamment, l'épaisseur _e_ de motif texturé du miroir **32** est inférieure ou égale à l'épaisseur du réseau périodique **18**, et comprise entre 0 et $\dfrac{\lambda}{10 \times \mathrm{Re}(n_2)}$ , , soit par exemple de l'ordre de 100 nm pour un réseau périodique **18** de 100 nm d'épaisseur.

Il a été décrit en relation avec les figures 2 et 3 un exemple de réalisation privilégiant une efficacité quantique élevé. Pour certaines applications, la largeur du pic d'absorption peut être considérée comme insuffisante.

En variante de réalisation, il est possible d'augmenter la largeur de ce pic diminuant la distance _d_ entre la couche semi-conductrice **14** et le réseau **18**.

La figure 13 illustre la réponse en absorption en fonction de différentes valeurs de distance _d_ pour une couche semi-conductrice **14** en MCT d'une épaisseur de 400 nm, un réseau monodimensionnel périodique **18** d'un pas _p_ de 1,45 μm, d'une largeur _l_ de 500 nm, d'une épaisseur de 50 nm et séparé du miroir **22** par une distance _h_ de 500 nm.

Dans cet exemple de réalisation, la distance _d_ varie de 10 nm (pic le plus large) à 300 nm (pic le plus fin). Comme on peut le constater, à mesure que _d_ augmente, la largeur du pic d'absorption augmente.

En variante, ou de manière complémentaire, il est possible de régler la largeur du pic d'absorption également en faisant varier l'épaisseur _t_ de la couche semi-conductrice **14**, mais au prix d'une remontée du fond continu, c'est-à-dire le niveau d'absorption en dehors du pic de résonance.

La figure 14 illustre la réponse en absorption en fonction de différentes valeurs d'épaisseur _t_ de la une couche semi-conductrice **14**, pour un réseau monodimensionnel périodique **18** d'un pas _p_ de 1,45 μm, d'une largeur _l_ de 500 nm, d'une épaisseur de 50 nm, séparé du miroir **22** par une distance _h_ de 500 nm et séparé de la couche 14 par une distance d de 50nm.

Dans cet exemple de réalisation, l'épaisseur _t_ de la couche **14** de 100 nm (pic de gauche, très faible) à 1000 nm (pic de droite).

Dans les deux cas illustrés aux figures 8 et 9, on garde une bonne efficacité à la résonance, à savoir une absorption supérieure à 60%.

**Revendications**

1. Détecteur à éclairage arrière pour la détection d'un rayonnement électromagnétique autour d'une longueur d'onde prédéterminée, comprenant :

    - une couche semi-conductrice d'absorption (14) pour l'absorption dudit rayonnement, formée au dessus d'un milieu au moins partiellement transparent audit rayonnement, et ayant une épaisseur apte à transmettre au moins une partie dudit rayonnement; et
    - un miroir (22 ; 32 ; 42 ; 68) disposé au dessus de la couche semi-conductrice (14) pour réfléchir un rayonnement reçu au travers de celle-ci,

    _caractérisé_ :

    - **en ce qu'**il comporte, disposé entre le miroir (22 ; 32 ; 42 ; 68) et la couche semi-conductrice (14), un réseau périodique (18) de motifs métalliques (20), le miroir (22 ; 32 ; 42 ; 68) et le réseau périodique (18) étant compris dans une couche de matériau (16) au moins partiellement transparent audit rayonnement et formée sur la couche semi-conductrice (14),
    - et **en ce que** le miroir (22 ; 32 ; 42 ; 68) et le réseau périodique (18) de motifs métalliques sont conçus pour vérifier les relations suivantes :

$$d \leq \frac{\lambda}{\text{Re}(n_1)}$$

$$\frac{\lambda}{16 \times \text{Re}(n_2)} + m \times \frac{\lambda}{2 \times \text{Re}(n_2)} \leq h \leq \frac{3 \times \lambda}{8 \times \text{Re}(n_2)} + m \times \frac{\lambda}{2 \times \text{Re}(n_2)}$$

$$\text{Re}(n_2) \leq 1,3 \times \text{Re}(n_1)$$

$$\text{Re}(n_1) \geq \text{Re}(n_{substrat})$$

où

- *Re* désigne la partie réelle;
- *d* est la distance entre la couche semi-conductrice (14) et le réseau périodique (18),
- *h* est la distance entre le miroir (22 ; 32 ; 42 ; 68) et le réseau périodique (18),
- *m* est un entier positif ou nul,
- λ est une longueur d'onde à laquelle la couche semi-conductrice (14) est absorbante,
- $n_1$ est l'indice de réfraction de la couche semi-conductrice (14),
- $n_2$ est l'indice de réfraction de la couche (16) dans laquelle sont formés le réseau périodique (18) et le miroir (22 ; 32 ; 42 ; 68) ; et
- $n_{substrat}$ est l'indice de réfraction du milieu (12) au dessus duquel est formée la couche semi-conductrice d'absorption (14).

2. Détecteur à éclairage arrière pour la détection d'un rayonnement électromagnétique selon la revendication 1, *caractérisé* en ce que le réseau de motifs de motifs métalliques (18) est conçu pour vérifier la relation suivante :

$$\frac{\lambda}{\text{Re}(n_1)} \leq p \leq \frac{\lambda}{\max\left(\text{Re}(n_2), \text{Re}(n_{substrat})\right)}$$

où *p* est le pas du réseau (18).

3. Détecteur à éclairage arrière pour la détection d'un rayonnement électromagnétique selon la revendication 1 ou 2, *caractérisé* en ce que la couche semi-conductrice (14) a une épaisseur inférieure à 500 nanomètres, et de préférence supérieure à 50 nanomètres.

4. Détecteur à éclairage arrière pour la détection d'un rayonnement électromagnétique selon la revendication 1, 2 ou 3, *caractérisé* en ce que l'épaisseur de la couche semi-conductrice (14) vérifie la relation $t \leq \frac{\lambda}{3 \times \text{Im}(n_1)}$, où *t* est l'épaisseur de la couche semi-conductrice (14) et *Im* désigne la partie imaginaire.

5. Détecteur à éclairage arrière pour la détection d'un rayonnement électromagnétique selon l'une quelconque des revendications précédentes, *caractérisé* en ce que la distance entre le miroir (22 ; 32 ; 42 ; 68) et le réseau périodique (18) est sensiblement égal à $\dfrac{\lambda}{4 \times \mathrm{Re}(n_2)}$ ou un multiple impaire de cette valeur.

**6.** Détecteur à éclairage arrière pour la détection d'un rayonnement électromagnétique selon l'une quelconque des revendications précédentes, *caractérisé* **en ce que** le réseau périodique (18) est monodimensionnel, et est notamment constitué de barres métalliques (20).

**7.** Détecteur à éclairage arrière pour la détection d'un rayonnement électromagnétique selon la revendication 6, *caractérisé* **en ce que** le facteur de remplissage *f* du réseau périodique (18) vérifie la $\dfrac{1}{5} \le f \le \dfrac{3}{4}$.

**8.** Détecteur à éclairage arrière pour la détection d'un rayonnement électromagnétique selon l'une quelconque des revendications 1 à 5, *caractérisé* **en ce que** le réseau est bidimensionnel, et est notamment constitué de trous ou de plots.

**9.** Détecteur à éclairage arrière pour la détection d'un rayonnement électromagnétique selon l'une quelconque des revendications précédentes, *caractérisé* **en ce que** le miroir (32) est métallique, et **en ce qu'**une face du miroir (32) en regard du réseau périodique (18) est texturée.

**10.** Détecteur à éclairage arrière pour la détection d'un rayonnement électromagnétique selon la revendication 9, *caractérisé* **en ce que** la texturation du miroir (32) est réalisée sur une épaisseur *e* vérifiant la relation $e \le \dfrac{\lambda}{10 \times \mathrm{Re}(n_2)}$.

**11.** Détecteur à éclairage arrière pour la détection d'un rayonnement électromagnétique selon l'une quelconque des revendications précédentes, *caractérisé* **en ce que** le réseau périodique (18) et/ou le miroir (22 ; 32 ; 68) sont réalisés en un métal à faibles pertes optiques, notamment en argent, en or, en cuivre ou en aluminium.

**12.** Détecteur à éclairage arrière pour la détection d'un rayonnement électromagnétique selon l'une quelconque des revendications 1 à 8, *caractérisé* **en ce que** le miroir (42) est un miroir de Bragg.

**13.** Détecteur à éclairage arrière pour la détection d'un rayonnement électromagnétique selon la revendication 12, *caractérisé* **en ce que** le miroir de Bragg (42) comprend au moins un bicouche (44, 46, 48) quart d'onde, notamment constitué d'une couche en germanium d'une épaisseur de $\dfrac{\lambda}{4 \times \mathrm{Re}(n_{Ge})}$ et d'une couche en sulfure de zinc d'une épaisseur de $\dfrac{\lambda}{4 \times \mathrm{Re}(n_{ZnS})}$, où $n_{Ge}$ et $n_{ZnS}$ sont respectivement les indices de réfraction du germanium et du sulfure de zinc.

**14.** Détecteur à éclairage arrière pour la détection d'un rayonnement électromagnétique selon l'une quelconque des revendications précédentes, *caractérisé* **en ce que** le rayonnement à détecter est un rayonnement infrarouge, et **en ce que** l'épaisseur du réseau périodique (18) est inférieure ou égale à 100 nm.

**15.** Détecteur à éclairage arrière pour la détection d'un rayonnement électromagnétique selon l'une quelconque des revendications précédentes, *caractérisé* **en ce que** la couche semi-conductrice d'absorption (14) est constituée d'un matériau semi-conducteur choisi dans le groupe constitué du CdHgTe, du InGaAs et des semi-conducteurs ternaires de type III-V comprenant du Sb, InSb, SiGe ou du Ge.

**16.** Détecteur à éclairage arrière pour la détection d'un rayonnement électromagnétique selon l'une quelconque des revendications précédentes, *caractérisé* **en ce que** la distance *d* entre la couche semi-conductrice (14) et le réseau périodique (18) est nulle, et **en ce que** le réseau périodique (18) constitue une électrode de collecte des photoporteurs générés dans la couche semi-conductrice (14).

**17.** Détecteur à éclairage arrière pour la détection d'un rayonnement électromagnétique selon l'une quelconque des revendications 1 à 15, *caractérisé* **en ce qu'**il comporte une diode de collecte (62) comprenant :

■ une zone semi-conductrice (64) formée dans la couche semi-conductrice d'absorption (14) et de conductivité électrique opposée à celle de la couche semi-conductrice d'absorption (14) ; et
■ une métallisation (66) agencée au contact de la zone semi-conductrice (64) pour la collecte de photoporteurs générés dans la couche semi-conductrice d'absorption (14).

**18.** Détecteur à éclairage arrière pour la détection d'un rayonnement électromagnétique selon la revendication 17, *caractérisé* **en ce que** le réseau périodique (18) le miroir (68) et la métallisation (66) sont court-circuités.

**19.** Détecteur à éclairage arrière pour la détection d'un rayonnement électromagnétique selon la revendication 17, *caractérisé* **en ce que** le réseau périodique (18) et le miroir (68) sont court-circuités et sont isolés électriquement de la métallisation (66).

**20.** Détecteur à éclairage arrière pour la détection d'un rayonnement électromagnétique selon la revendication 17, *caractérisé* **en ce que** le réseau périodique (18), le miroir (68) et la couche semi-conductrice d'absorption (14) sont court-circuités, et ce que le réseau périodique (68) et le miroir (66) sont isolés électriquement de la métallisation (66).

**21.** Détecteur à éclairage arrière pour la détection d'un rayonnement électromagnétique selon la revendication 17, *caractérisé* **en ce que** le miroir (68) et la métallisation (66) sont court-circuités et isolés électriquement du réseau périodique (18).

**22.** Détecteur à éclairage arrière pour la détection d'un rayonnement électromagnétique selon la revendication 21, *caractérisé* **en ce que** le réseau périodique (18) et la couche semi-conductrice d'absorption (14) sont court-circuités et isolés électriquement de la métallisation (66).

**23.** Détecteur à éclairage arrière pour la détection d'un rayonnement électromagnétique selon la revendication 17, *caractérisé* **en ce que** la métallisation (66) traverse sans contact le miroir (68) et le réseau périodique (18).

**Fig. 1**

réseau métallique mince - miroir face arrière

**Fig. 2**

**Fig. 3**

Rayonnement incident

**Fig. 4**

**Fig. 5**

Rayonnement incident

**Fig. 6**

**Fig. 7**

**Fig. 8**

**Fig. 9**

**Fig. 10**

**Fig. 11**

**Fig. 12A**

**Fig. 12B**

**Fig. 12C**

**Fig. 12D**

**Fig. 12E**

**Fig. 12F**

**Fig. 12G**

**Fig. 13**

**Fig. 14**

## EP 2 477 231 A2

### RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005081782 A

**Littérature non-brevet citée dans la description**

- **C. HAASE ; H. STIEBIG.** Optical Properties of Thin-film Silicon Solar Cells with Grating Couplers. *Progress in photovoltaics: research and applications,* 2006, vol. 14, 629-641